# EUROPEAN PATENT SPECIFICATION

(11) **EP 3 101 683 B1**
(45) Date of publication and mention of the grant of the patent: **16.06.2021**
(21) Application number: 15740594.5
(22) Date of filing: 13.01.2015
(51) Int. Cl.: H01L 21/306, H01L 21/02, H01L 21/304, H01L 21/67, H01L 21/762, H01L 21/265

(54) **SEMICONDUCTOR-WAFER CLEANING TANK AND METHOD FOR MANUFACTURING BONDED WAFER**
HALBLEITER-WAFER-REINIGUNGSTANK UND VERFAHREN ZUR HERSTELLUNG EINES GEBONDETEN WAFERS
CUVE DE NETTOYAGE DE TRANCHES SEMI-CONDUCTRICES ET PROCÉDÉ DE FABRICATION DE TRANCHE LIÉE

(30) Priority: 27.01.2014 JP 2014012267
(43) Date of publication of application: 07.12.2016
(73) Proprietor: Shin-Etsu Handotai Co., Ltd., Tokyo 100-0004 (JP)
(72) Inventor: NAGAOKA, Yasuo, Annaka-shi Gunma 379-0196 (JP)
(74) Representative: Wibbelmann, Jobst
(86) International application number: PCT/JP2015/000102
(87) International publication number: WO 2015/111383

(56) References cited:
- CN-A- 1 685 476
- JP-A- H0 449 619
- JP-A- H10 311 653
- JP-A- S62 284 140
- JP-A- 2001 023 952
- JP-A- 2002 331 430
- JP-A- 2004 343 013
- JP-A- 2012 015 490
- US-A1- 2011 290 279

## Description

### BACKGROUND OF THE INVENTION

### 1. Field of the Invention

The present invention relates to a semiconductor-wafer cleaning tank and a method of manufacturing a bonded wafer by an ion implantation delamination method using the cleaning tank, and particularly to a method of manufacturing a silicon-on-insulator (SOI) wafer that is required to have an SOI layer 30 nm or less thick with a film-thickness uniformity of ±0.5 nm in the wafer plane, referred to as extremely thin SOI (ETSOI).

### 2. Description of the Related Art

A method of manufacturing an SOI wafer by delaminating an ion-implanted wafer after bonding, i.e., the ion implantation delamination method (a technique also referred to as the Smart Cut method (registered trademark)), has attracted attention as a method of manufacturing an SOI wafer, particularly a method of manufacturing an SOI wafer having a thin SOI layer that enables improvement in performance of advanced integrated circuits.

This ion implantation delamination method is a technique to form an SOI wafer (See Patent Literature 1) in the following manner: an oxide film is formed on at least one of two silicon wafers; gas ions such as hydrogen ions or rare gas ions are implanted from a front surface of one of the silicon wafers (a bond wafer) to form an ion implantation layer (also referred to as a micro bubble layer or an enclosed layer) in the interior of the wafer; the surface from which the ions are implanted is then brought into close contact with the other silicon wafer (a base wafer) through the oxide film; a heat treatment (a delamination heat treatment) is then performed to cleave one of the wafers (the bond wafer) along the micro bubble layer so that the bond wafer is separated into a thin film; and another heat treatment (a bonding heat treatment) is then performed to strengthen a bond between the wafers. At this point, the cleavage plane (the delamination surface) is a surface of an SOI layer, and an SOI wafer having a thin SOI with high uniformity is relatively easily obtained.

The surface of the delaminated SOI wafer, however, contains a damaged layer due to ion implantation, and has surface roughness larger than a mirror surface of a usual silicon wafer. Accordingly, it is necessary to remove such damaged layer and surface roughness in the ion implantation delamination method. Conventionally, mirror polishing with extremely small polishing stock removal (a stock removal of about 100 nm), referred to as touch polishing, has been performed in order to remove the damaged layer and the like in the final step after the bonding heat treatment. However, when polishing including a mechanical processing element is performed with respect to the SOI layer, since the stock removal of the polishing is not uniform, there occurs a problem of deteriorating film-thickness uniformity of the SOI layer achieved by implantation of hydrogen ions or the like and delamination.

For the purpose of solving such a problem, a flattening process involving heat treatment at a high temperature has been performed to improve the surface roughness instead of touch polishing (Patent Literature 2, 3, and 4). The flattening process allows the ion implantation delamination method to mass-produce SOI wafers each having a diameter of 300 mm and excellent film-thickness uniformity in which a film-thickness range (a value obtained by subtracting a minimum value from a maximum value in in-plane film-thickness) of each SOI layer is within 3 nm (i.e., ±1.5 nm in the wafer plane).

On the other hand, for a thickness-reduction processing after delamination in the ion implantation delamination method, there have been disclosed a method for reducing the film thickness uniformly in a plane by etching the SOI layer with a mixed aqueous solution containing ammonia water and hydrogen peroxide water (SC1) (Patent Literature 5) and a method for adjusting the film thickness of the SOI layer by etching with SC1 (Patent Literature 6).Patent Literature 7 describes a substrate processing apparatus including an outer tank and a process tank with a heat insulation wall outside of the process tank. Patent Literature 8 refers to an ultrasonic cleaning tank.

### CITATION LIST

### PATENT LITERATURE

Patent Literature 1: Japanese Unexamined Patent publication (Kokai) No. H05-211128
Patent Literature 2: Japanese Unexamined Patent publication (Kokai) No. H11-307472
Patent Literature 3: Japanese Unexamined Patent publication (Kokai) No. 2000-124092
Patent Literature 4: Re-publication of PCT International Publication No. 2003/009386
Patent Literature 5: Japanese Unexamined Patent publication (Kokai) No. 2000-173976
Patent Literature 6: Japanese Unexamined Patent publication (Kokai) No. 2004-311526
Patent Literature 7: US 2011/290279 A1
Patent Literature 8: JPH04-49619

### SUMMARY OF THE INVENTION

With the recent popularization of mobile terminals, lower power consumption, miniaturization, and higher performance have been required in semiconductor devices. As a potential candidate for 22-nm design rule or later generation, fully depleted devices using SOI wafers have been developed. In the fully depleted device, the SOI layer is extremely thinned to about 10 nm, and thickness distribution of the SOI layer affects threshold voltage of the device. Thus, the in-plane thickness distribution of the SOI layer is required to have a film-thickness uniformity in which the film-thickness range is 1 nm or less (i.e., ±0.5 nm in the wafer plane). However, this requirement is extremely difficult to be achieved in mass-production level.

The present invention was accomplished in view of the above-described problems. It is a purpose of the present invention to provide a method that can manufacture, in high yield, bonded wafers keeping film-thickness uniformity even after etching for adjusting the film thickness, and a cleaning solution tank for use in the etching.

To achieve this purpose, the present invention provides a semiconductor-wafer cleaning tank in which a semiconductor wafer is immersed in a cleaning solution and cleaned, comprising: a tank body, composed of quartz, for storing the cleaning solution to immerse a plurality of the semiconductor wafers in the cleaning solution; an overflow-receiving part, composed of quartz and provided around an opening of the tank body, for receiving the cleaning solution overflowing from an upper end of the opening of the tank body; and a heat-insulating wall provided around the tank body, wherein the heat-insulating wall forms a continuous enclosure around a side wall of the tank body with a hollow layer formed between the heat-insulating wall and the side wall of the tank body, the heat-insulating wall extends from the overflow-receiving part downward and is connected to the lower portion of the overflow-receiving part.

Such a semiconductor-wafer cleaning tank can reduce heat radiation from the wall of the tank body by the hollow layer formed between the heat-insulating wall and the side wall of the tank body, and can improve temperature uniformity in the wall of the tank body by air convection generated in the hollow layer. Thus, temperature uniformity of the cleaning solution in the tank body can be improved. When this tank is used for the etching step for adjusting the film thickness, bonded wafers keeping film-thickness uniformity even after etching for adjusting the film thickness can be manufactured in high yield.

The heat-insulating wall extends from the overflow-receiving part downward.

Because the wall of the tank body easily radiates heat below the overflow-receiving part, the heat-insulating wall is preferably provided at this portion.

It is preferred that a bottom of the overflow-receiving part be located above an upper end of the immersed semiconductor wafer, and a lower end of the heat-insulating wall be located below a lower end of the immersed semiconductor wafer.

This configuration more greatly improves temperature uniformity of the cleaning solution around the entire immersed semiconductor wafers.

A lower portion of the heat-insulating wall may be open.

This configuration allows cold air accumulated in the bottom of the heat-insulating wall to be escaped.

A lower portion of the heat-insulating wall may be closed, and the heat-insulating wall may be provided with an air vent.

When the lower portion of the heat-insulating wall is closed, heat can be prevented from radiating from the lower portion of the heat-insulating wall. When the air vent is provided, the heat-insulating wall can be prevented from breaking due to air expansion.

A straightening plate may be provided at a lower portion of the heat-insulating wall.

The straightening plate, provided at the lower portion of the heat-insulating wall so as to form a flow channel, increases a surface area of the flow channel, and thus enhances heat insulating property.

The straightening plate is preferably provided below a lower end of the immersed semiconductor wafer.

This configuration more greatly improves temperature uniformity of the cleaning solution around the entire immersed semiconductor wafers.

Furthermore, the present invention provides a method of manufacturing a bonded wafer, comprising: implanting one or more gas ions selected from a hydrogen ion and a rare gas ion from a surface of a bond wafer to form an ion implantation layer in an interior of the bond wafer; bonding the surface from which the ion is implanted into the bond wafer and a surface of a base wafer directly or through an insulator film; delaminating the bond wafer along the ion implantation layer to form a bonded wafer having a thin film on the base wafer; and processing the thin film to reduce a thickness of the thin film, wherein the processing the thin film to reduce a thickness of the thin film includes an etching stage of etching the thin film by immersing the bonded wafer in a chemical solution tank filled with an etching solution, a temperature of which is controlled, to adjust the thickness of the thin film, and the etching stage includes etching the thin film by using the above semiconductor-wafer cleaning tank as the chemical solution tank.

When the above semiconductor-wafer cleaning tank is used as the chemical solution tank in the etching stage for adjusting the thickness of the thin film, temperature uniformity of the chemical solution in the chemical solution tank can be improved, and thus bonded wafers keeping film-thickness uniformity even after etching for adjusting the film thickness can be manufactured in high yield.

The bond wafer may be a silicon wafer, and the etching solution may be a mixed aqueous solution containing ammonia water and hydrogen peroxide water.

The silicon wafer can be suitably used as the bond wafer.

The mixed aqueous solution containing ammonia water and hydrogen peroxide water, which has high performance of removing particles and organic impurities, can be suitably used as the etching solution.

The temperature of the etching solution is preferably controlled to 50°C or higher and 80°C or lower.

When the temperature of the etching solution is 50°C or higher, the etching rate is appropriate, and the film-thickness adjustment does not take a lot of time. When the temperature of the etching solution is 80°C or lower, the etching rate is not excessively high, and thus suitable for adjusting the film thickness.

As mentioned above, when the cleaning tank of the present invention is used for adjusting the thickness of the thin film (the SOI layer), the film thickness can be adjusted extremely uniformly, and thus bonded wafers required to have a film-thickness uniformity of the thin film of ±0.5 nm in the wafer plane can be manufactured in high yield.

### BRIEF DESCRIPTION OF DRAWINGS

FIG. 1 is a schematic cross-sectional view showing an exemplary semiconductor-wafer cleaning tank according to the first embodiment of the present invention;
FIG. 2 is a schematic view showing an example of a cleaning line used in the etching stage in the method of manufacturing a bonded wafer of the present invention;
FIGS. 3 are a front view, a lateral view, a top view, and a bottom view of a semiconductor-wafer cleaning tank according to the first embodiment of the present invention;
FIG. 4 is a schematic cross-sectional view showing an exemplary semiconductor-wafer cleaning tank according to the second embodiment of the present invention;
FIGS. 5 are a front view, a lateral view, a top view, and a bottom view of a semiconductor-wafer cleaning tank according to the second embodiment of the present invention;
FIG. 6 is a graph in which stock removal is compared among wafers in one batch in experimental example;
FIG. 7 is a graph in which stock removal is compared in the wafer plane in experimental example; and
FIG. 8 is an explanatory view showing positions R/2 left and right from the center line of the wafer subjected to film-thickness measurement in experimental example.

### DETAILED DESCRIPTION OF THE PREFERRED EMBODIMENTS

As mentioned above, the in-plane thickness distribution of the SOI layer is required to have a film-thickness uniformity in which the film-thickness range is 1 nm or less (i.e., ±0.5 nm in the wafer plane). However, when the thin film (the SOI layer) is formed by the ion implantation delamination method, the thin film right after delamination already has some film-thickness range (<1nm) due to in-plane variation in the ion implantation depth. Thus, in order to obtain a final product including an SOI layer with a film-thickness uniformity of ±0.5 nm in the wafer plane, it is important to prevent deterioration of the thickness-film range (or improve the thickness-film range) in the film-thickness adjustment (such as sacrificial oxidation treatment, flattening heat treatment, and etching) after delamination. In regard to this, Japanese Unexamined Patent publication (Kokai) No. 2013-125909 discloses a manufacturing method in which an ion implantation condition and a sacrificial oxidation condition are modified to obtain the final product including the SOI layer with a film-thickness uniformity of ±0.5 nm in the wafer plane.

This manufacturing method can prevent deterioration of the thickness-film range (or improve the thickness-film range) after delamination by modifying the ion implantation condition and the sacrificial oxidation condition. On the other hand, when processes such as sacrificial oxidation treatment and flattening heat treatment are performed, multiple cleaning steps (etching steps) with a chemical solution such as SC1 are performed before and after the processes. Thus, it is necessary to consider uniformity of stock removal of the SOI layer in a plane and among wafers in the cleaning steps.

The present inventors have diligently conducted studies and found the following. Although temperature of the chemical solution such as SC1 is generally adjusted with an accuracy of ±1°C in the chemical solution tank, temperature around the wall of the chemical solution tank is lower than the temperature of the chemical solution. Thus, heat is taken away from each plane of the wall of the chemical solution tank by heat exchange of the wall of the chemical solution tank, resulting in a decrease in temperature. Consequently, wafers placed within the chemical solution tank subtly vary in stock removal of the SOI layer, depending on the wafer plane or a slot position. This variation of stock removal is extremely small, and thus hardly affects film-thickness uniformity after cleaning in the case of a relatively thick SOI layer (for example, 100 nm or more). However, this variation is considerable in the case of ET-SOI. The present invention was brought to completion from these findings.

Hereinafter, the present invention will be described in detail, but the present invention is not limited thereto.

Herein, an example in which the bonded wafer is an SOI wafer manufactured with silicon wafers is described, but the "bonded wafer" in the present invention is not limited to an SOI wafer or a silicon wafer.

In other words, the invention can be applied to any methods of manufacturing a bonded wafer by the ion implantation delamination method which includes thickness-reduction processing by etching.

For example, there may be mentioned a case in which a wafer such as a SiGe wafer or a compound semiconductor wafer is bonded to silicon, quartz, Al₂O₃ or the like. In this case, the bond wafer to be boned may include no insulator film. The etching solution may be any solution capable of etching the formed thin film, and is appropriately selected based on the bond wafer to be used.

The method of manufacturing a bonded wafer of the present invention begins with forming a bonded wafer having a thin film on a base wafer. The bonded wafer may be formed by a known method, the ion implantation delamination method (also referred to as the Smart Cut method (registered trademark)). Specifically, the bonded wafer having a thin film on a base wafer can be formed in the following manner: an ion implantation layer is formed in an interior of a bond wafer by implanting one or more gas ions selected from hydrogen ions and rare gas ions from the surface of the bond wafer; the surface from which the ion is implanted into the bond wafer and the surface of the base wafer are bonded directly or through an insulator film; and the bond wafer is delaminated along the ion implantation layer.

The bond wafer is preferably, but not particularly limited to, a silicon wafer.

The bonded wafer used in the thickness-reduction processing (the etching step) is preferably a bonded wafer having a thin film (an SOI layer) with a film-thickness range within 3 nm (i.e., ±1.5 nm in the wafer plane), more preferably within 1 nm (i.e., ±0.5 nm in the wafer plane), manufactured by the ion implantation delamination method.

A sacrificial oxidation treatment and a flattening heat treatment may be performed after delamination. The sacrificial oxidation treatment and the flattening heat treatment can be performed according to known methods.

After forming the bonded wafer, the thin film is processed to reduce its thickness.

The thickness-reduction processing is performed by immersing the bonded wafer after delamination in the cleaning tank (a chemical solution tank) of the present invention filled with an etching solution temperature of which is controlled, and thereby etching the thin film. In the present invention, the etching is carried out under the condition where the chemical solution tank is surrounded by the heat-insulating wall with the hollow layer.

Hereinafter, the etching step (the cleaning step) in the method of manufacturing a bonded wafer of the present invention will be described in more detail with reference to drawings.

### (First Embodiment)

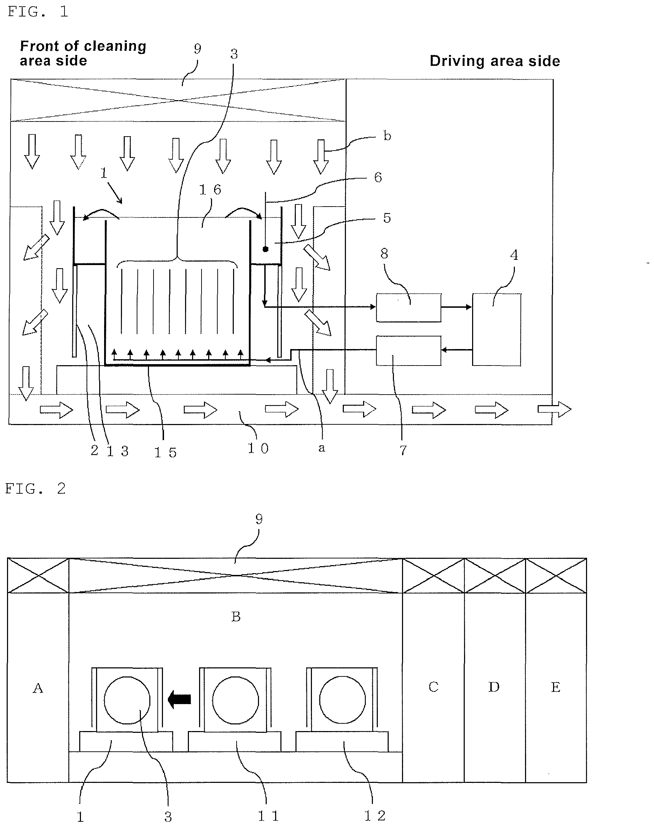

FIG. 1 is a schematic cross-sectional view of a chemical solution tank (a cleaning tank) 1 according to the first embodiment used in the etching step.

Bonded wafers 3 after delamination are placed within the chemical solution tank 1. An etching solution (a cleaning solution) 16 such as SC1 circulates, in a direction of the solid arrow a in FIG. 1, by means of a pump 8 in a driving area shown at right of FIG. 1 to etch.

The temperature of the etching solution is controlled with a thermometer 6 placed in an overflow-receiving part 5 and a heater 7, based on proportional integral differential (PID) control, so as to have a desired temperature (for example, 70±1°C). The etching solution returned to the pump 8 from the overflow-receiving part 5 passes through a filter 4, is controlled again with the heater 7 so as to have the desired temperature, and enters the chemical solution tank 1.

In addition, downflow of clean air, as shown by the hollow arrow b, is formed through an air filter 9 provided above the chemical solution tank 1. The clean air flows around the chemical solution tank 1, then passes through an exhaust duct 10 on the side wall and the bottom, and discharges through a main exhaust port.

In the conventional etching step, this clean air exchanges heat with the chemical solution tank 1 and a rinsing tank. Thus, slight temperature distribution occurs around the chemical solution tank 1 and in the chemical solution, which causes slight variation of stock removal in the wafer plane and among the wafers.

By contrast, in the present invention the heat-insulating wall 2 is provided around the tank body 15, and the hollow layer 13 is thereby formed between the heat-insulating wall 2 and the side wall of the tank body 15. This hollow layer 13 can reduce heat radiation from the side wall of the tank body 15, and can improve temperature uniformity in the side wall of the tank body 15 by air convection generated in the hollow layer.

Etching using such a chemical solution tank 1 can reduce the temperature variation of the etching solution 16 in the chemical solution tank 1. Thus, etching (cleaning) can be performed with extremely high stock-removal uniformity in the wafer plane and among the wafers. In other words, film-thickness uniformity can be kept even after etching.

Additionally, heat-insulating property of the hollow layer 13 can be increased by sandblasting the surface of the heat-insulating wall 2.

The heat-insulating wall 2 extends from the overflow-receiving part 5 downward.

Because the wall of the tank body 15 easily radiates heat below the overflow-receiving part 5, the heat-insulating wall 2 is provided at this portion.

It is preferred that the bottom of the overflow-receiving part 5 is located above the upper end of the immersed semiconductor wafers 3, and the lower end of the heat-insulating wall 2 is located below the lower end of the immersed semiconductor wafers 3.

This configuration more greatly improves temperature uniformity of the etching solution (the cleaning solution) 16 around the entire immersed semiconductor wafers 3.

In the first embodiment, the lower portion of the heat-insulating wall 2 is open.

This configuration allows cold air accumulated in the bottom of the heat-insulating wall 2 to be escaped.

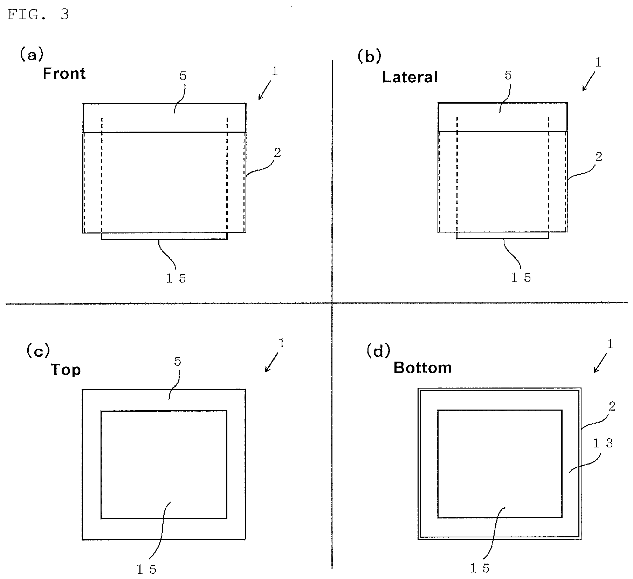

The heat-insulating wall 2 is, as shown in FIGS. 3, provided around the tank body 15 continuously. This configuration allows the side wall of the tank body 15 to keep good temperature uniformity, regardless of the environment around the tank body 15.

### (Second Embodiment)

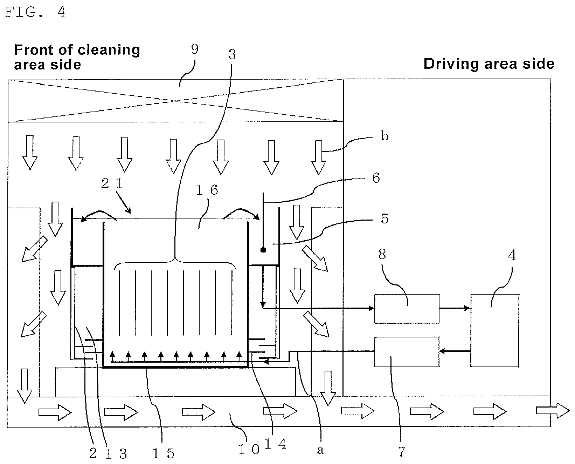

FIG. 4 is a schematic cross-sectional view of a chemical solution tank (a cleaning tank) 21 according to the second embodiment used in the etching step.

The chemical solution tank (the cleaning tank) 21 of the second embodiment is different from the chemical solution tank (the cleaning tank) 1 of the first embodiment in that a straightening plate 14 for forming a flow channel is provided at the lower portion of the heat-insulating wall 2.

The straightening plate 14, provided at the lower portion of the heat-insulating wall 2 to form a flow channel, increases a surface area of the flow channel, and thus enhances heat insulating property, as well as allowing cold air accumulated in the bottom of the heat-insulating wall 2 to be escaped.

The straightening plate 14 is preferably provided below the lower end of the immersed semiconductor wafers 3.

This configuration more greatly improves temperature uniformity of the etching solution (the cleaning solution) 16 around the entire immersed semiconductor wafers 3.

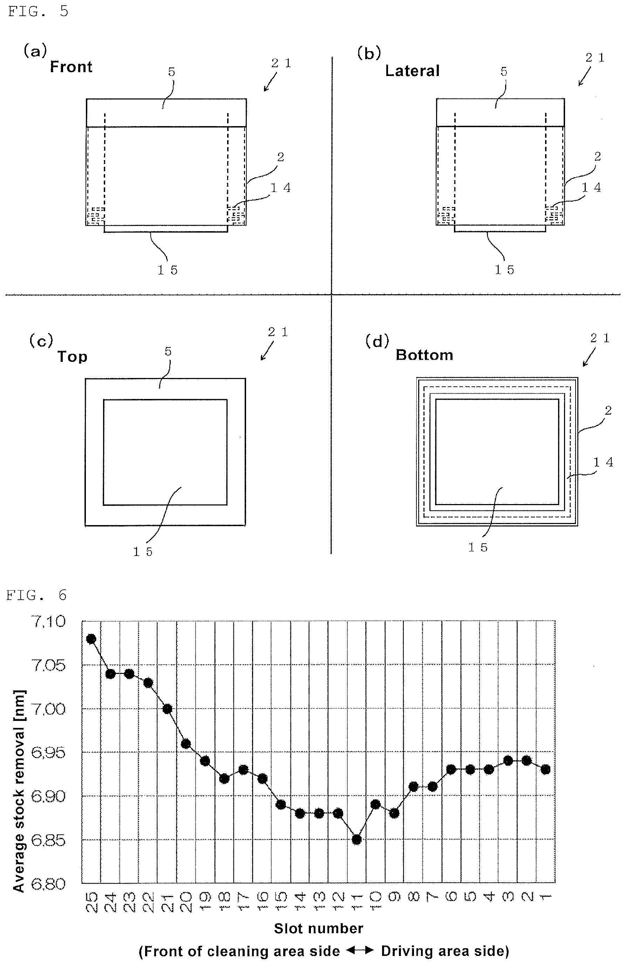

The heat-insulating wall 2 and the straightening plate 14 are, as shown in FIGS. 5, provided around the tank body 15 continuously. This configuration allows the side wall of the tank body 15 to keep good temperature uniformity, regardless of the environment around the tank body 15.

Alternatively, the lower portion of the heat-insulating wall 2 may be closed, and the heat-insulating wall 2 may be provided with an air vent.

When the lower portion of the heat-insulating wall is closed, heat can be prevented from radiating from the lower portion of the heat-insulating wall. When the air vent is provided, the heat-insulating wall can be prevented from breaking due to air expansion.

In the case that a silicon wafer is used as the bond wafer, the etching solution is preferably a mixed aqueous solution containing ammonia water and hydrogen peroxide water, SC1, which has a function of etching silicon.

SC1, which can remove particles and organic impurities, is effective and frequently used in a process for manufacturing an SOI wafer by the ion implantation delamination method.

The temperature of the etching solution is preferably controlled to a prescribed temperature ranging from 50°C to 80°C (for example, 70°C).

When the temperature of the etching solution is 50°C or higher, the etching rate is appropriate, and the film-thickness adjustment does not take a lot of time. When the temperature of the etching solution is 80°C or lower, the etching rate is not excessively high, and thus suitable for adjusting the film thickness.

The entire etching step (the cleaning step) in the method of manufacturing a bonded wafer of the present invention is performed in a cleaning line as shown in FIG. 2, for example.

In FIG. 2, A is a loading area, B is a first cleaning area (with alkali), C is a second cleaning area (with acid), D is a drying area, and E is an unloading area. In area B, the first cleaning area (with alkali), etching is performed by using the cleaning solution tank 1, shown in FIG. 1, filled with an alkali etching solution such as SC1, and then rising is performed by using rinsing tanks 11 and 12. In area C, the second cleaning area (with acid), etching and rinsing are performed with an acid etching solution such as SC2 (a mixed aqueous solution containing hydrochloric acid and hydrogen peroxide water, which has no function of etching silicon), in the same manner as in the first cleaning area.

Incidentally, FIG. 1 is a schematic cross-sectional view of the chemical solution tank 1, viewed in a direction of the arrow in FIG. 2.

Of course, the etching step in the method of manufacturing a bonded wafer of the present invention can be applied to an etching step (a cleaning step) of a usual mirror-polished wafer (a PW wafer). However, since the thickness of the PW wafer is controlled in the order of µm, the etching step in the method of manufacturing a bonded wafer of the present invention, which aims to strictly adjust stock removal less than nm, cannot fully exhibit the effect in the application to the PW wafer.

As described above, when the cleaning tank of the present invention is used for adjusting the thickness of the thin film (the SOI layer), the thickness can be adjusted extremely uniformly, and thus bonded wafers required to have a film-thickness uniformity of the thin film of ±0.5 nm in the wafer plane can be manufactured in high yield.

### EXAMPLES

Hereinafter, the present invention will be specifically described with reference to experimental example, example, and comparative example, but the present invention is not limited thereto.

### (Experimental Example)

As described above, it is supposed that the clean air in FIG. 1 exchanges heat with the chemical solution tank 1 in FIG. 1 and the rinsing tank 11 in FIG. 2, and thus, slight temperature distribution occurs around the chemical solution tank and in the chemical solution, which causes slight variation of stock removal in the wafer plane and among the wafers.

Because it is difficult to measure slight temperature deference (among the wafers and in the wafer plane) in the cleaning solution during cleaning (etching), SOI wafers in one batch (25 SOI wafers, each includes a base wafer of a 300-mm diameter silicon single crystal wafer, a buried oxide film layer composed of SiO₂, and an SOI layer composed of a silicon single crystal layer being stacked in this order) were cleaned repeatedly in the first cleaning area shown by B of FIG. 2, and then stock removal among the wafers and in the wafer plane was examined.

FIG. 6 is a graph in which stock removal is compared among the wafers in one batch. This graph shows average stock removal (average values of stock removal obtained by measuring the thickness of the entire surface of the SOI layer before and after cleaning) at slot positions of a wafer carrier on which the 25 SOI wafers were each placed.

The graph of FIG. 6 shows that, in the wafer carrier, the wafers placed on the driving area side (the main exhaust side) had smaller stock removal. In other words, it is supposed that the solution temperature on the driving area side (the main exhaust side) is relatively low.

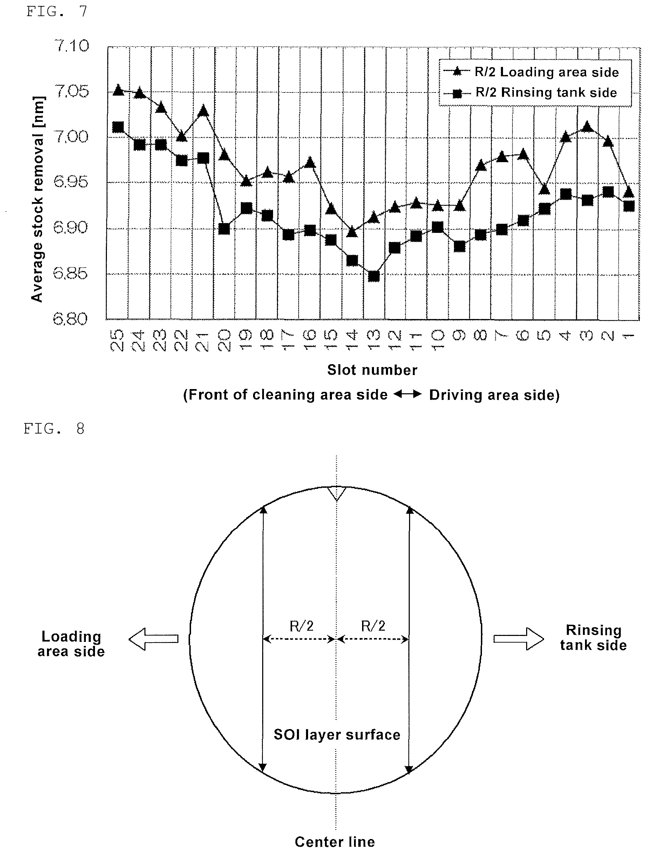

Subsequently, stock removal was compared in the wafer plane in the following manner; an SOI wafer was placed in the wafer carrier with a notch located at the top of the wafer surface, and cleaned repeatedly; the film thickness of the wafer before and after cleaning was measured at positions R/2 (R denotes radius) left and right from the center line of the wafer (see FIG. 8); and average stock removal at both the measurement positions was calculated and plotted on a graph shown in FIG. 7.

The graph of FIG. 7 shows that the plane on the rinsing tank side had smaller stock removal than the other plane on the loading area side. In other words, it is supposed that the solution temperature on the rinsing area side is relatively low.

### (Example and Comparative Example)

In the first cleaning area B in the cleaning line of FIG. 2 (the cleaning area in the cleaning line of FIG. 1), SOI wafers in one batch (25 SOI wafers) were cleaned (etched) repeatedly, and stock removal in case of using the cleaning tank 1 including the heat-insulating wall 2 according to the first embodiment of the invention (Example) was compared with that in case of using a conventional cleaning tank not including a heat-insulating wall (Comparative Example).

### [Cleaning condition]

### (Cleaning flow)

SC1(75±1°C)→Rinse(25°C)→Rinse(25°C) was repeated 6 times.

### (Cleaning tank)

Material: transparent quartz, 3 mm thick (common to the tank body, the overflow-receiving part, and the heat-insulating wall)

### Structure:

### (Overflow-receiving part)

The bottom of the overflow-receiving part was located 30 mm above the upper end of the wafers to be cleaned.

### (Heat-insulating wall)

The heat-insulating wall was provided 30 mm below the lower end of the wafers to be cleaned.

### [Wafer to be used]

The wafer used were 25 SOI wafers (having a diameter of 300 mm, with crystal orientation of <100>) each manufactured by the ion implantation delamination method (using silicon single crystal wafers as the bond wafer and the base wafer), subjected to a sacrificial oxidation treatment and a flattening heat treatment after delamination, and controlled to have an SOI layer with an average thickness of 90 nm and a film-thickness range (in the wafer plane) of 1.0 nm (±0.5 nm). The 25 SOI wafers were also controlled to have a film-thickness range (maximum - minimum) among the wafers in a batch of 1.0 nm.

### [SOI film thickness measurement]

The entire surface (4237 points) except for a peripheral portion within 3 mm from the edge was measured with Acumap made by ADE Corp.

**[Table 1]**

| Evaluation item | Example | Comparative Example |
|---|---|---|
| Average stock removal in batch (average value of 25 wafers) (nm) | 6.92 | 6.94 |
| Stock removal tolerance in batch (maximum - minimum) (nm) | 0.06 | 0.39 |
| Average film thickness of plane on rinsing tank side (average value of 25 wafers: T1) (nm) | 6.89 | 6.56 |
| Average film thickness of plane on loading area side (average value of 25 wafers: T2) (nm) | 6.92 | 6.96 |
| Average stock removal range (T2-T1) (nm) | 0.03 | 0.40 |

| | | |
|---|---|---|
| Unit (nm) | | |

As shown in Table 1, the 25 wafers in Example, after cleaning with SC1 6 times, exhibited a small stock removal tolerance in a batch of 0.06 nm and a small average stock removal range of 0.03 nm, and thus substantially kept a film-thickness uniformity in which the film-thickness range was within 1.0 nm (±0.5 nm) among the wafers and in the wafer plane. By contrast, the 25 wafers in Comparative Example exhibited a large stock removal tolerance in a batch of 0.39 nm and a large average stock removal range of 0.40 nm, and thus deteriorated the film-thickness range to about 1.4 nm among the wafers and in the wafer plane.

As described above, it was revealed that when the cleaning tank of the present invention is used for adjusting the thickness of the thin film (the SOI layer), the thickness can be adjusted extremely uniformly, and thus bonded wafers keeping film-thickness uniformity even after etching for adjusting the film thickness can be manufactured in high yield.

It is to be noted that the present invention is not limited to the foregoing embodiment. The embodiment is just an exemplification, the scope of the invention being defined by the appended claims.

## Claims

1. A semiconductor-wafer cleaning tank (1) in which a semiconductor wafer is immersed in a cleaning solution and cleaned, comprising:
a tank body (15), composed of quartz, for storing the cleaning solution to immerse a plurality of the semiconductor wafers in the cleaning solution;
an overflow-receiving part (5), composed of quartz and provided around an opening of the tank body, for receiving the cleaning solution overflowing from an upper end of the opening of the tank body; and
a heat-insulating wall provided around the tank body, wherein
the heat-insulating wall (2) forms a continuous enclosure around a side wall of the tank body with a hollow layer (13) formed between the heat-insulating wall and the side wall of the tank body, the semiconductor-wafer cleaning tank being **characterized in that**
the heat-insulating wall extends from the overflow-receiving part downward and is in contact with the lower portion of the overflow-receiving part.

2. The semiconductor-wafer cleaning tank according to claim 1, wherein a lower portion of the heat-insulating wall (2) is open.

3. The semiconductor-wafer cleaning tank according to claim 1 wherein a lower portion of the heat-insulating wall (2) is closed, and the heat-insulating wall is provided with an air vent.

4. The semiconductor-wafer cleaning tank according to claim 1 or 2, wherein a straightening plate (14) is provided at a lower portion of the heat-insulating wall.

5. The semiconductor-wafer cleaning tank according to claim 4, wherein the straightening plate (14) is provided below a lower end of the immersed semiconductor wafer.

6. A method of manufacturing a bonded wafer, comprising:
implanting one or more gas ions selected from a hydrogen ion and a rare gas ion from a surface of a bond wafer to form an ion implantation layer in an interior of the bond wafer;
bonding the surface from which the ion is implanted into the bond wafer and a surface of a base wafer directly or through an insulator film;
delaminating the bond wafer along the ion implantation layer to form a bonded wafer having a thin film on the base wafer; and
processing the thin film to reduce a thickness of the thin film, wherein the processing the thin film to reduce a thickness of the thin film includes an etching stage of etching the thin film by immersing the bonded wafer in a chemical solution tank filled with an etching solution, a temperature of which is controlled, to adjust the thickness of the thin film, and the etching stage includes etching the thin film by using a semiconductor-wafer cleaning tank according to any one of claims 1 to 5 as the chemical solution tank.

7. The method of manufacturing a bonded wafer according to claim 6, wherein the bond wafer is a silicon wafer, and the etching solution is a mixed aqueous solution containing ammonia water and hydrogen peroxide water.

8. The method of manufacturing a bonded wafer according to claim 6 or claim 7, wherein the temperature of the etching solution is controlled to 50°C or higher and 80°C or lower.

## Patentansprüche

1. Halbleiter-Wafer-Reinigungstank (1), in dem ein Halbleiter-Wafer in eine Reinigungslösung eingetaucht und gereinigt wird, umfassend:
einen Tankkörper (15), der aus Quarz besteht, zum Speichern der Reinigungslösung, um eine Vielzahl der Halbleiterwafer in die Reinigungslösung einzutauchen;
ein Überlauf-Aufnahmeteil (5), das aus Quarz besteht und um eine Öffnung des Tankkörpers herum vorgesehen ist, um die Reinigungslösung aufzunehmen, die aus einem oberen Ende der Öffnung des Tankkörpers überläuft; und
eine wärmeisolierende Wand, die um den Tankkörper herum vorgesehen ist, wobei
die wärmeisolierende Wand (2) eine kontinuierliche Umhüllung um eine Seitenwand des Tankkörpers mit einer hohlen Schicht (13) bildet, die zwischen der wärmeisolierenden Wand und der Seitenwand des Tankkörpers gebildet ist, wobei der Halbleiterwafer-Reinigungstank **dadurch gekennzeichnet ist, dass** sich die wärmeisolierende Wand von dem Überlaufaufnahmeteil nach unten erstreckt und in Kontakt mit dem unteren Abschnitt des Überlaufaufnahmeteils ist.

2. Halbleiterwafer-Reinigungsbehälter nach Anspruch 1, wobei ein unterer Teil der wärmeisolierenden Wand (2) offen ist.

3. Halbleiterwafer-Reinigungsbehälter nach Anspruch 1, wobei ein unterer Teil der wärmeisolierenden Wand (2) geschlossen ist und die wärmeisolierende Wand mit einer Entlüftung versehen ist.

4. Halbleiterwafer-Reinigungsbehälter nach Anspruch 1 oder 2, wobei an einem unteren Abschnitt der wärmeisolierenden Wand eine Richtplatte (14) vorgesehen ist.

5. Halbleiterwafer-Reinigungsbehälter nach Anspruch 4, wobei die Richtplatte (14) unterhalb eines unteren Endes des eingetauchten Halbleiterwafers vorgesehen ist.

6. Verfahren zur Herstellung eines gebondeten Wafers, umfassend:
Implantieren von einem oder mehreren Gasionen, ausgewählt aus einem Wasserstoffion und einem Edelgasion, von einer Oberfläche eines Bondwafers, um eine Ionenimplantationsschicht in einem Inneren des Bondwafers zu bilden;
Verbinden der Oberfläche, von der das Ion implantiert wurde, mit dem Bond-Wafer und einer Oberfläche eines Basis-Wafers direkt oder durch einen Isolatorfilm
Delaminieren des Bondwafers entlang der Ionenimplantationsschicht, um einen gebondeten Wafer mit einem Dünnfilm auf dem Basiswafer zu bilden; und
Verarbeiten des Dünnfilms, um eine Dicke des Dünnfilms zu reduzieren, wobei das Verarbeiten des Dünnfilms, um eine Dicke des Dünnfilms zu reduzieren, einen Ätzschritt des Ätzens des Dünnfilms durch Eintauchen des gebondeten Wafers in einen chemischen Lösungsbehälter, der mit einer Ätzlösung gefüllt ist, deren Temperatur gesteuert wird, umfasst, um die Dicke des Dünnfilms einzustellen, und der Ätzschritt das Ätzen des Dünnfilms unter Verwendung eines Halbleiterwafer-Reinigungsbehälters nach einem der Ansprüche 1 bis 5 als chemischer Lösungsbehälter umfasst.

7. Verfahren zur Herstellung eines gebondeten Wafers nach Anspruch 6, wobei der gebondete Wafer ein Siliziumwafer ist und die Ätzlösung eine gemischte wässrige Lösung ist, die Ammoniakwasser und Wasserstoffperoxidwasser enthält.

8. Verfahren zur Herstellung eines gebondeten Wafers nach Anspruch 6 oder Anspruch 7, wobei die Temperatur der Ätzlösung auf 50°C oder höher und 80°C oder niedriger geregelt wird.

## Revendications

1. Cuve de nettoyage de plaquette de semi-conducteur (1) dans laquelle une plaquette de semi-conducteur est immergée dans une solution de nettoyage et nettoyée, comprenant :
un corps de cuve (15), composé de quartz, pour stocker la solution de nettoyage pour immerger une pluralité de plaquettes de semi-conducteur dans la solution de nettoyage ;
une partie de réception de trop-plein (5), composée de quartz et prévue autour d'une ouverture du corps de cuve, pour recevoir la solution de nettoyage débordant d'une extrémité supérieure de l'ouverture du corps de cuve ; et
une paroi calorifuge prévue autour du corps de cuve, dans laquelle
la paroi calorifuge (2) forme une enceinte continue autour d'une paroi latérale du corps de cuve avec une couche creuse (13) formée entre la paroi calorifuge et la paroi latérale du corps de cuve, la cuve de nettoyage de plaquette de semi-conducteur étant **caractérisée en ce que** la paroi calorifuge s'étend de la partie de réception de trop-plein vers le bas et est en contact avec la partie inférieure de la partie de réception de trop-plein.

2. Cuve de nettoyage de plaquette de semi-conducteur selon la revendication 1, dans laquelle une partie inférieure de la paroi calorifuge (2) est ouverte.

3. Cuve de nettoyage de plaquette de semi-conducteur selon la revendication 1, dans laquelle une partie inférieure de la paroi calorifuge (2) est fermée, et la paroi calorifuge est pourvue d'un évent.

4. Cuve de nettoyage de plaquette de semi-conducteur selon la revendication 1 ou 2, dans laquelle une plaque de redressement (14) est prévue au niveau d'une partie inférieure de la paroi calorifuge.

5. Cuve de nettoyage de plaquette de semi-conducteur selon la revendication 4, dans laquelle la plaque de redressement (14) est prévue sous une extrémité inférieure de la plaquette de semi-conducteur immergée.

6. Procédé de fabrication d'une plaquette liée, comprenant :
l'implantation d'un ou plusieurs ions de gaz choisis parmi un ion hydrogène et un ion de gaz rare à partir d'une surface d'une plaquette de liaison pour former une couche à implantation ionique à l'intérieur de la plaquette de liaison ;
la liaison de la surface à partir de laquelle l'ion est implanté dans la plaquette de liaison et d'une surface d'une plaquette de base directement ou par l'intermédiaire d'un film isolant ;
le délaminage de la plaquette de liaison le long de la couche à implantation ionique pour former une plaquette liée ayant un film mince sur la plaquette de base ; et
le traitement du film mince pour réduire une épaisseur du film mince, dans lequel le traitement du film mince pour réduire une épaisseur du film mince comprend une étape de gravure de gravure du film mince par immersion de la plaquette liée dans un cuve de solution chimique remplie d'un solution de gravure, dont une température est régulée, pour ajuster l'épaisseur du film mince, et l'étape de gravure comprend la gravure du film mince en utilisant une cuve de nettoyage de plaquette de semi-conducteur selon l'une quelconque des revendications 1 à 5 comme cuve de solution chimique.

7. Procédé de fabrication d'une plaquette liée selon la revendication 6, dans lequel la plaquette de liaison est une plaquette de silicium, et la solution de gravure est une solution aqueuse mixte contenant de l'eau ammoniacale et de l'eau oxygénée.

8. Procédé de fabrication d'une plaquette liée selon la revendication 6 ou la revendication 7, dans lequel la température de la solution de gravure est régulée à 50 °C ou plus et 80 °C ou moins.
